# EUROPEAN PATENT APPLICATION

(11) **EP 2 950 345 A1**
(43) Date of publication of application: **02.12.2015**
(21) Application number: 14170385.0
(22) Date of filing: 28.05.2014
(51) Int. Cl.: H01L 27/146

(54) **Large-area image sensor module and method of producing a large-area image sensor**

(71) Applicant: ams AG, 8141 Unterpremstätten (AT)
(72) Inventor: Stockmeier, Thomas, 8141 Unterpremstätten (AT); Forsyth, Richard, 8054 Mantscha (AT); Troxler, Thomas, 8703 Erlenbach (AT)
(74) Representative: Epping - Hermann - Fischer

(57) **Abstract**

The semiconductor image sensor module comprises an image sensor array (2) arranged on a carrier wafer (1), a pixel array (3) provided by the image sensor array and at least one readout circuit (4) integrated in the image sensor array. The pixel array covers an area including a square area (10) having a side length (D) of more than 200 mm, and the image sensor array is formed by a plurality of image sensor chips each having a size below the size of a wafer scale image sensor.

## Description

An increasing demand for large-area CMOS image sensors is caused by the application of flat panel detectors in solid-state x-ray digital radiography. The required detector area is typically several 100 cm² large and can be covered by tiling with image sensor chips. If only one image sensor chip is produced on each wafer, the yield of image sensor chips rendering the desired performance may be inadequate with respect to the manufacturing costs.

CN 103531601 A discloses a large-area CMOS image sensor for detecting X-rays. An array of image sensor chips is arranged on a printed circuit board. Pixels, timing sequence generation circuits and buffer output circuits are provided on P-type silicon substrates. The distance between pixels in corresponding positions on edges of the adjacent image sensor chips is the same or 1.5 times as large as the distance between two adjacent pixels on the same image sensor chip.

It is an object of the present invention to disclose a large-area semiconductor image sensor for economical manufacture. It is a further object of the invention to disclose an economical method of producing a large-area image sensor.

These objects are achieved with the semiconductor image sensor module according to claim 1 and with the method of producing a semiconductor image sensor according to claim 9. Embodiments and variants derive from the dependent claims. The semiconductor image sensor module comprises an image sensor array arranged on a carrier wafer, a pixel array provided by the image sensor array and at least one readout circuit integrated in the image sensor array. The image sensor array is formed by a plurality of image sensor chips each having a size below the size of a wafer scale image sensor.

In an embodiment of the semiconductor image sensor module, the image sensor chips each have a lateral dimension of less than 100 mm.

In a further embodiment, the pixel array may especially cover an area including a square area having a side length of at least 200 mm.

In a further embodiment, some of the image sensor chips are arranged with three sides abutting on adjacent ones of the image sensor chips.

In a further embodiment, some of the image sensor chips are arranged with four sides abutting on adjacent ones of the image sensor chips.

A further embodiment comprises further readout circuits, each of the image sensor chips having one of the readout circuit or the further readout circuits as an integrated circuit.

In a further embodiment, each of the readout circuit or the further readout circuits is a CMOS circuit.

A further embodiment comprises through-substrate vias forming electric connections in the image sensor chips and a wiring arranged between the image sensor chips and the carrier wafer, the through-substrate vias being electrically connected with the wiring.

The method of producing a large-area image sensor comprises providing a plurality of image sensor chips from wafers by producing more than a single image sensor chip on each wafer, and arranging an array of the image sensor chips on a carrier wafer. In particular, a pixel array thus formed may cover an area including a square area having a side length of more than 200 mm. The image sensor chips may each have a lateral dimension of less than 100 mm, for instance.

In further embodiments, some of the image sensor chips are arranged with three or even four sides abutting on adjacent ones of the image sensor chips.

In a further embodiment, the carrier wafer is a semiconductor wafer larger than the wafers used for producing the image sensor chips.

In a further embodiment, readout circuits are integrated in the image sensor chips.

In a further embodiment, through-substrate vias are provided in the image sensor chips, a wiring is arranged between the image sensor chips and the carrier wafer, and the through-substrate vias are electrically connected with the wiring.

The following is a detailed description of examples of the semiconductor image sensor module and the method of producing a semiconductor image sensor in conjunction with the appended figures.
- Figure 1: is a top view of an image sensor module including image sensor chips that are arranged with three sides abutting on adjacent image sensor chips.
- Figure 2: is a top view of a wafer scale image sensor.
- Figure 3: is a top view of an image sensor module including image sensor chips that are arranged with four sides abutting on adjacent image sensor chips.
- Figure 4: is the cross section of the image sensor module indicated in Figure 3.

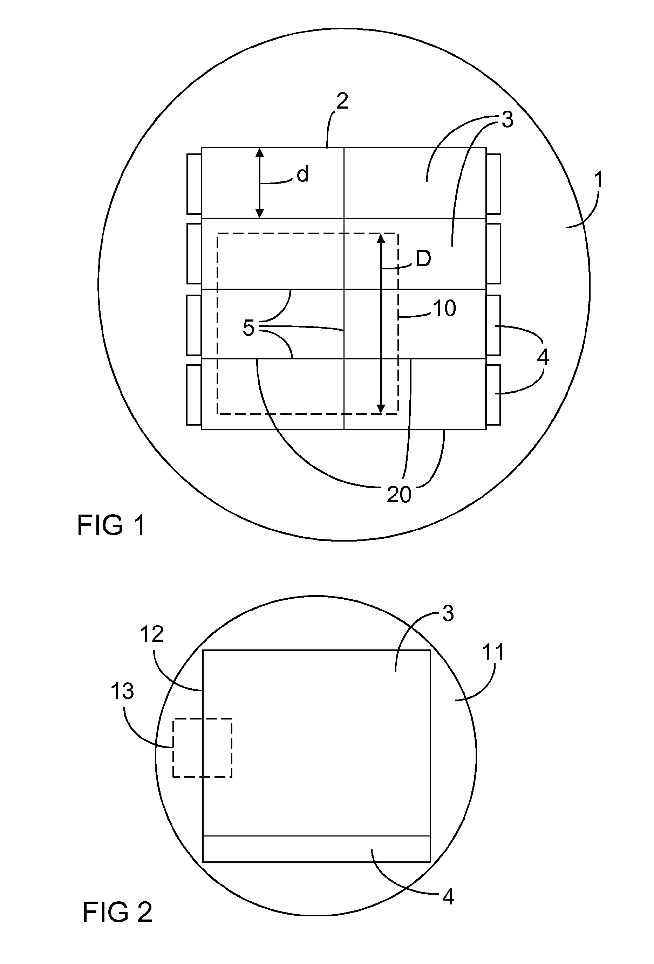

Figure 1 is a top view of an image sensor module comprising an image sensor array 2 on a carrier wafer 1, which may be glass or a semiconductor material like silicon, for instance. The image sensor array 2 is formed by an arrangement of image sensor chips 20, which are each smaller than a wafer scale image sensor, and provides a pixel array 3 and at least one readout circuit 4. In the embodiment shown in Figure 1, each image sensor chip 20 contributes to the pixel array 3, which forms the sensing area including a square area 10 of side length D at least 200 mm. Furthermore, each image sensor chip 20 may have an integrated readout circuit 4.

It is favorable if at least some of the image sensor chips 20 have three lateral sides 5 that allow butting against an adjacent image sensor chip 20. In this case, the image sensor chips 20 can be arranged in a dense array, so that some of the image sensor chips 20 have three of their lateral sides 5 abutting on the adjacent image sensor chips 20, as shown in Figure 1. This allows the pixel arrays 3 to be combined to a continuous sensing area. A lateral dimension d of the image sensor chips 20 is smaller than the dimensions of a wafer scale image sensor and may be typically less than 100 mm.

The image sensor chips 20 can be produced with high accuracy to have the required lateral dimensions, so that the image sensor chips 20 can be arranged very closely to one another in order to obtain a continuous tesselation forming the sensing area with extremely narrow seams or joints between the contiguous image sensor chips 20. Furthermore, the material of the carrier wafer 1, especially silicon, can be chosen to have the same or almost the same thermal expansion coefficient as the substrate material of the image sensor chips 20, which may be silicon, for instance, so that a thermal expansion is not liable to produce gaps between the image sensor chips 20.

Figure 2 is a top view of a wafer scale image sensor, which is not used according to the invention. A semiconductor wafer 11 is used to produce a wafer scale image sensor 12 having dimensions as large as feasible. A square CMOS image sensor chip produced on a 200 mm wafer may typically have side lengths of approximately 135 mm. Figure 2 shows an example of an arrangement of a pixel array 3 and an integrated readout circuit 4. Instead of the single wafer scale image sensor 12, a plurality of conventional chips 13 of smaller size, as indicated by the square broken contour in Figure 2, may be produced on the wafer 11. The manufacture of a plurality of small chips on the wafer 11 has the advantage of a higher yield of chips that are free from defects.

The carrier wafer 1 used according to the invention may be larger than the wafer 11 used for manufacturing the image sensor chips 20. As an example, the carrier wafer 1 may typically have a diameter of 300 mm, while the image sensor chips 20 applied in the image sensor array 2 may have been manufactured on a 200 mm wafer.

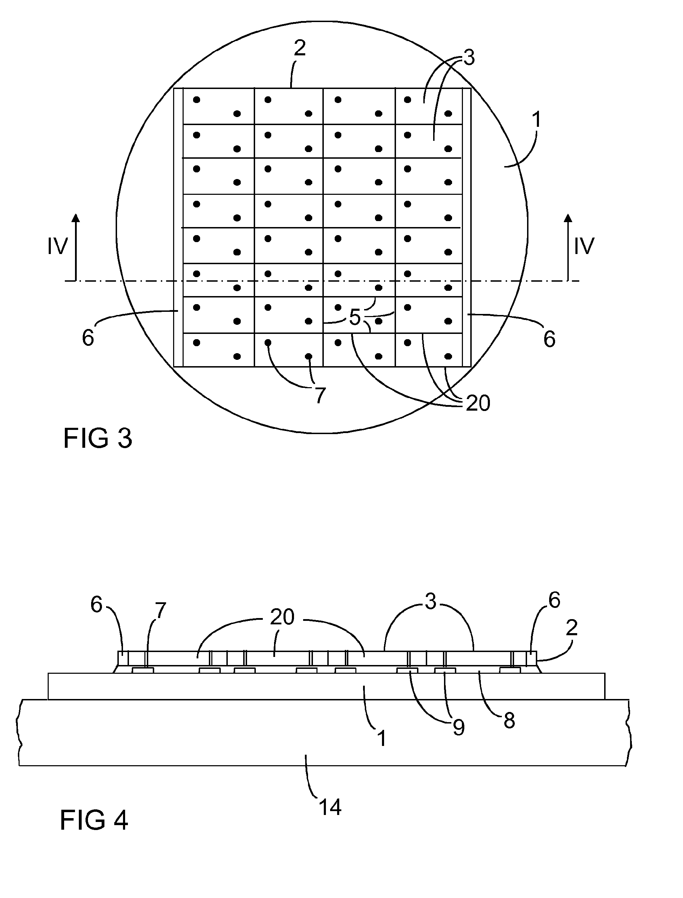

Figure 3 is a top view of an image sensor module including image sensor chips 20 that are arranged with four lateral sides 5 abutting on adjacent image sensor chips 20. Elements of the embodiment according to Figure 3 that are similar to corresponding elements of the embodiment according to Figure 1 are designated with the same reference numerals. The embodiment according to Figure 3 comprises image sensor chips 20 that can be arranged with all four lateral sides 5 abutting on the adjacent image sensor chips 20. The image sensor array 2 can therefore include inner image sensor chips 20 that are completely surrounded by further image sensor chips 20.

In order to provide electric connections for the inner image sensor chips 20 as well, the image sensor chips 20 can be arranged upside down in the manner of a flip-chip assembly, so that contact pads of the readout circuits 4 can directly be connected with a wiring on the carrier wafer 1. The image sensor chips 20 can especially comprise back-illuminated sensors for this purpose. Connection areas 6 may also be provided at the periphery of the image sensor array 2. As additional connections or instead of the connections already described, through-substrate vias 7 can be provided as electric interconnections through the image sensor chips 20. Through-substrate vias 7 are especially suitable to connect a pixel array 3 and/or a readout circuit 4 arranged on an upper surface with conductors or with a wiring arranged on the rear side of the image sensor chips 20, opposite to the upper surface carrying the pixel array 3.

Figure 4 is a cross section of the image sensor module according to Figure 3. The position of the cross section is indicated in Figure 3. Figure 4 shows the arrangement of the image sensor array 2 formed by a plurality of image sensor chips 20 on a carrier wafer 1. The image sensor chips 20 can be attached to the carrier wafer 1 by means of a bonding layer 8, which may be an oxide of the semiconductor material, for instance. A standard bonding equipment, which may be specially adapted, can be used for this purpose. Through-substrate vias 7 may be electrically connected to a wiring 9 arranged between the image sensor chips 20 and the carrier wafer 1. Image sensor chips 20 that are mounted with contact pads facing the carrier wafer 1 may be electrically connected with the wiring 9 by anisotropic conductive films, for instance. Other suitable connection techniques known per se from semiconductor technology may be adopted as well.

The carrier wafer 1 may be larger than the image sensor array 2. The use of a carrier wafer 1 that exceeds the area of the image sensor array 2 provides space for additional clamping, heat sinking and/or flex foil attachment around the image sensor array 2. The carrier wafer 1 can be fastened on a board 14 or any part of a device using the image sensor array 2. The electric connections between the carrier wafer 1 and the board 14 can be provided by further interconnections not shown in Figure 4. By arranging several carrier wafers 1 on the board 14, even larger sensing areas may be obtained.

The invention allows the manufacture of large-area CMOS image sensors at high yield and low costs.

### List of reference numerals

- 1: carrier wafer
- 2: image sensor array
- 3: pixel array
- 4: readout circuit
- 5: lateral side allowing butting
- 6: connection area
- 7: through-substrate via
- 8: bonding layer
- 9: wiring
- 10: square area
- 11: wafer
- 12: wafer scale chip
- 13: conventional chip
- 14: board
- 20: image sensor chip
- d: lateral dimension
- D: side length

## Claims

1. A semiconductor image sensor module, comprising:
- an image sensor array (2) arranged on a carrier wafer (1),
- a pixel array (3) provided by the image sensor array (2), and
- at least one readout circuit (4) integrated in the image sensor array (2),
**characterized in that**
- the image sensor array (2) is formed by a plurality of image sensor chips (20) each having a size below the size of a wafer scale image sensor (12).

2. The semiconductor image sensor module of claim 1, wherein the pixel array (3) covers an area including a square area (10) having a side length (D) of at least 200 mm.

3. The semiconductor image sensor module of claim 1 or 2,
wherein the image sensor chips (20) each have a lateral dimension (d) of less than 100 mm.

4. The semiconductor image sensor module of one of claims 1 to 3, wherein
some of the image sensor chips (20) are arranged with three lateral sides (5) abutting on adjacent ones of the image sensor chips (20).

5. The semiconductor image sensor module of one of claims 1 to 4, wherein
some of the image sensor chips (20) are arranged with four lateral sides (5) abutting on adjacent ones of the image sensor chips (20).

6. The semiconductor image sensor module of one of claims 1 to 5, further comprising:
further readout circuits (4), each of the image sensor chips (20) having one of the readout circuit (4) or the further readout circuits (4) as an integrated circuit.

7. The semiconductor image sensor module of claim 6, wherein each of the readout circuit (4) or the further readout circuits (4) is a CMOS circuit.

8. The semiconductor image sensor module of one of claims 1 to 7, further comprising:
through-substrate vias (7) forming electric connections in the image sensor chips (20), and
a wiring (9) arranged between the image sensor chips (20) and the carrier wafer (1), the through-substrate vias (7) being electrically connected with the wiring (9).

9. A method of producing a large-area image sensor, comprising:
providing a plurality of image sensor chips (20) from wafers (11) by producing more than a single image sensor chip on each wafer (11), and
arranging an array of the image sensor chips (20) on a carrier wafer (1).

10. The method of claim 9, wherein
a pixel array (3) is formed by the image sensor chips (20), the pixel array (3) covering an area including a square area (10) having a side length (D) of more than 200 mm, and the image sensor chips (20) each have a lateral dimension (d) of less than 100 mm.

11. The method of claim 9 or 10, wherein
some of the image sensor chips (20) are arranged with three lateral sides (5) abutting on adjacent ones of the image sensor chips (20).

12. The method of one of claims 9 to 11, wherein
some of the image sensor chips (20) are arranged with four lateral sides (5) abutting on adjacent ones of the image sensor chips (20).

13. The method of one of claims 9 to 12, wherein
the carrier wafer (1) is a semiconductor wafer larger than the wafers (11) used for producing the image sensor chips (20).

14. The method of one of claims 9 to 13, further comprising:
readout circuits (4) integrated in the image sensor chips (20).

15. The method of one of claims 9 to 14, further comprising:
through-substrate vias (7) being provided in the image sensor chips (20),
a wiring (9) being arranged between the image sensor chips (20) and the carrier wafer (1), and
the through-substrate vias (7) being electrically connected with the wiring (9).
